# EUROPEAN PATENT APPLICATION

(11) **EP 2 876 811 A1**
(43) Date of publication of application: **27.05.2015**
(21) Application number: 13306594.6
(22) Date of filing: 21.11.2013
(51) Int. Cl.: H03H 11/12

(54) **Tuning a tunable filter**

(71) Applicant: ALCATEL LUCENT, 92100 Boulogne-Billancourt (FR)
(72) Inventor: Ferling, Dieter, 70435 Stuttgart (DE); Rheinschmitt, Rupert, 70435 Stuttgart (DE); Yu, Xin, 70435 Stuttgart (DE)
(74) Representative: 2SPL Patentanwälte PartG mbB

(57) **Abstract**

Embodiments relate to a concept for tuning a tunable filter (102). A signal (106) indicative of a current filter characteristic of the tunable filter (102) is determined based on an interaction of a reference signal (108) with the tunable filter (102) having the current filter characteristic. The signal (106) indicative of the current filter characteristic is compared with a signal (112) indicative of a desired filter characteristic of the tunable filter (102). One or more settings (116) of the tunable filter (102) are updated base on the comparison in order to approximate the desired filter characteristic

## Description

Embodiments generally relate to systems employing analog or digital filters and, particularly to tunable filters for mobile communication system devices.

### Background

This section introduces aspects that may be helpful in facilitating a better understanding of embodiments of the present invention. Accordingly, the statements of this section are to be read in this light and are not to be understood as admissions about what is in the prior art or what is not in the prior art.

Analog and digital filters are commonly used in the field of electrical engineering. Example applications include analog and digital signal processing, such as audio or video signal processing. Analog and digital filters are also widely spread in the field of telecommunications, be it wired or wireless communications, such as mobile communication systems.

A digital filter performs mathematical operations on a sampled, discrete-time signal to reduce or enhance certain aspects of that signal. For example, digital filters may be used for separation of signals that have been combined, or restoration of signals that have been distorted in some way. An analog signal may be processed by a digital filter by first being digitized and represented as a sequence of numbers, then manipulated mathematically, and then reconstructed as a new analog signal.

Analog filters may be used for the same or similar purposes. In an analog filter, the input signal may be "directly" manipulated by the circuit. Analog filters may be regarded as continuous-time filters, or filters that can be implemented with resistors, capacitors, inductors, specialized elements or devices, etc. In wireless communication devices analog filters may be used as receive or transmit filters for Radio Frequency (RF) signals, for example.

### Summary

Some simplifications may be made in the following summary, which is intended to highlight and introduce some aspects of the various example embodiments, but such simplifications are not intended to limit the scope of embodiments. Detailed descriptions of one or more preferred exemplary embodiments adequate to allow those of ordinary skill in the art to make and use the inventive concepts will follow in later sections.

According to a first aspect embodiments provide an apparatus for tuning a tunable filter. The apparatus includes a determination module to determine a signal indicative of a current filter characteristic of the filter based on an interaction of a reference signal with the filter having the current filter characteristic. Further, the apparatus includes a comparison module to compare the signal indicative of the current filter characteristic with a signal indicative of a desired filter characteristic of the filter. The apparatus also includes an update module to update, based on the comparison, one or more settings of the tunable filter to approach the desired filter characteristic.

According to a second aspect embodiments provide a method for tuning a tunable filter. The method includes determining a signal indicative of a current filter characteristic of the filter based on an interaction of a reference signal with the filter having the current filter characteristic, comparing the signal indicative of the current filter characteristic with a signal indicative of a desired filter characteristic of the filter, and updating, based on the comparison, one or more settings of the tunable filter to approach the desired filter characteristic of the filter.

Some embodiments comprise a digital control circuit installed within the tuning apparatus. Such a digital control circuit, e.g. a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the tuning method, when the computer program is executed on a programmable hardware device.

For example, the current filter characteristic of the tunable filter may deviate from the desired filter characteristic due to unwanted effects, such as filter component aging, an influence of temperature on the filter components, power supply variation, manufacturing tolerance, etc. Such effects may change or vary values of filter components. A filter characteristic may include frequency characteristics of amplitude and/or phase of the filter, such as the amplitude and/or phase transfer function, for example.

In some embodiments the tunable filter may be an analog filter. The analog filter may be a passive or active filter employing tunable resistive elements, tunable capacitive elements, tunable inductive elements, and/or tunable active elements or active devices, such as operational amplifiers, for example. The tunable filter may be implemented by means of one or more tunable resonating circuits or resonators, for example. Thereby, tuning may be performed by electronically and/or mechanically varying one or more control parameters for one or more tunable filter components. One of many examples for an electronic control parameter is a control voltage of one or more filter components. For mechanically controlled variable capacitors, for example, the distance between the plates, or the amount of plate surface area which overlaps, can be changed.

In one or more embodiments, the tunable filter may be a tunable analog Radio Frequency (RF) filter and the reference signal may be an analog RF signal, for example employing one or more frequencies in the range of several MHz to several GHz. In some embodiments the tunable filter may be a transmit filter or receive filter of a base station or a mobile station of a mobile communication system, such as 3^{rd} Generation Partnership Project (3GPP) Long-Term Evolution (LTE). The tuning apparatus may hence be included in or coupled to a base station or a mobile station of a mobile communication system. Some embodiments address tuning of filters in mobile stations or base stations during operation to correct unforeseeable disturbing modification of frequency characteristics due to temperature modification, aging of components or other reasons. Such a feature allows the use of filters of high accuracy, lower cost, size and weight with reduced stability of frequency characteristic.

In some embodiments the determination module may comprise a digital baseband module operable to determine a digital baseband signal originating from the interaction of the reference signal with the tunable filter having the current frequency characteristic. In this way the digital baseband signal is indicative of the current frequency characteristic of the tunable filter. Hence, the filter characteristic of a tunable analog RF filter may be determined by means of analyzing a digital baseband signal resulting from the interaction of a RF reference signal with the tunable analog RF filter having the current filter characteristic, for example. The reference signal may include a known training signal comprising predetermined pilot symbols, for example. Said reference signal may be fed to an input port of the tunable filter. Depending on an application (for example, base station or a mobile station) the reference signal may be an uplink reference signal or a downlink reference signal of a mobile communication system, such as LTE, for example. However, also other reference signals independent from uplink and/or downlink communication are possible. For example, the reference signal may be generated by the apparatus itself.

In embodiments there may be various types of interaction of the reference signal with the tunable filter. In one example the reference signal may pass through the tunable filter. In this case the signal indicative of the current frequency characteristic of the filter may be derived from a filter output signal, for example by down-conversion and/or analog-to-digital conversion. In another example the reference signal may be reflected from the input of the tunable filter. In this case the signal indicative of the current frequency characteristic of the filter may be derived from the reflected signal, for example by down-conversion and/or analog-to-digital conversion. As has been explained before, the reference signal interacting with the tunable filter may be an analog RF signal, while the resulting signal indicative of the current frequency characteristic may be a digital baseband signal. Hence, there may be a down-conversion module between the filter and the determination module.

In some embodiments the comparison module may be operable or configured to compare a digital baseband signal corresponding to the current frequency characteristic with a digital baseband reference signal corresponding to an interaction of the reference signal with the tunable filter having the desired frequency characteristic within the frequency band of interest. Hence, the digital baseband reference signal may be a known predetermined signal resulting from the reference signal passing through or being reflected from the tunable filter with the desired (reference) filter characteristic. For example, said digital baseband reference signal may be stored in a digital memory module, which is accessible by the comparison module. The comparison module may further be operable or configured to evaluate a difference or deviation between the digital baseband signal corresponding to the current frequency characteristic and the digital baseband reference signal. The difference of the two baseband signals may then be indicative of a difference between the current and the desired filter characteristic.

The update module may be operable or configured to adjust at least one control setting of the tunable filter in order to reduce a difference between the signal indicative of the current frequency characteristic and the signal indicative of the desired frequency characteristic. The at least one control setting may be from the group consisting of a control voltage of one or more filter components, a control setting for a tunable inductance of the tunable filter, a control setting for a tunable capacitance of the tunable filter, and a control setting for a tunable resistance of the tunable filter.

Embodiments allow to operate tunable filters of simple construction of high accuracy, lower cost, size and weight (e.g. with no temperature compensation implemented). Embodiments allow to compensate disturbing short time effects, e.g. due to temperature modification, as well as disturbing long time effects, e.g. due to material aging. Embodiments enable the operation of tunable filters of reduced stability with regard to their frequency characteristics but with an advantage of high accuracy, lower cost, size and weight.

### Brief description of the Figures

Some embodiments of apparatuses and/or methods will be described in the following by way of example only, and with reference to the accompanying figures, in which
- Fig. 1: illustrates a schematic block diagram of an example embodiment of an apparatus for tuning a tunable filter;
- Fig. 2: illustrates a block diagram of a further embodiment of an apparatus for tuning a tunable filter;
- Fig. 3a: shows a drift of frequency characteristic due to temperature modification of 50 °C; and
- Fig. 3b: shows a corrected temperature drift of frequency characteristic.

### Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

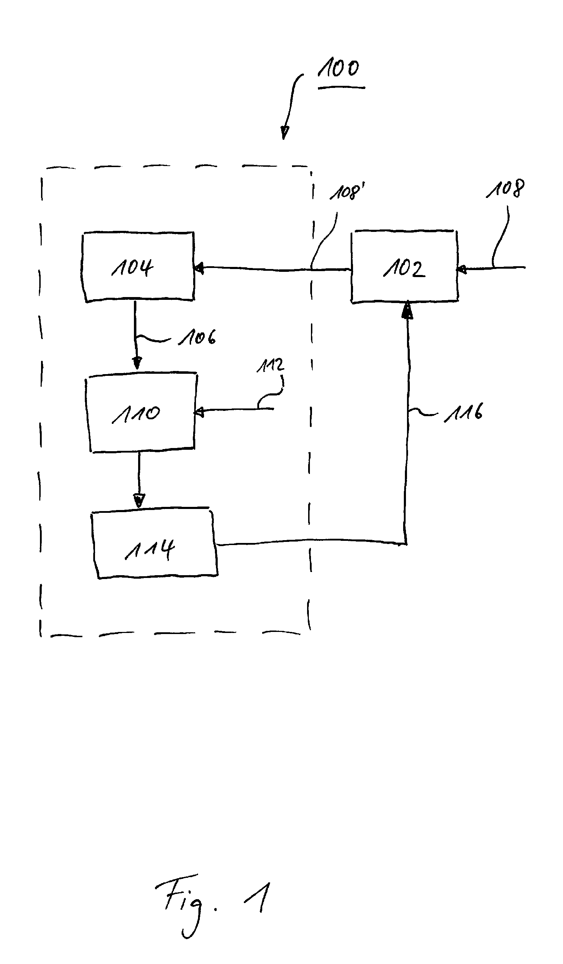

**Fig. 1** illustrates a schematic block diagram of an example embodiment of an apparatus 100 for tuning or adjusting a tunable filter 102.

The apparatus 100 comprises a determination module 104. The determination module 104 is configured to determine a signal 106 which is indicative of a current filter characteristic of the tunable filter 102. Thereby the current filter characteristic may relate to a frequency and/or phase characteristic of the filter 102 and deviate from a desired filter characteristic, for example due to component aging or temperature effects. Hence, the current filter characteristic may be undesired. The determination of the signal 106 is based on an interaction of a reference signal 108 or a signal containing a reference signal and other data with the tunable filter 102 having the current (undesired) filter characteristic. Hence, the reference signal 108 may be signal including a known reference signal (e.g. reference symbols) or including both a known reference signal and other data. The apparatus 100 further comprises a comparison module 110. The comparison module 110 is configured to compare the signal 106 indicative of the current filter characteristic with a further signal 112 indicative of the desired filter characteristic of the filter 102. The apparatus 100 also comprises an update module 114. The update module 114 is configured update, based on the comparison performed by the comparison module 110, one or more digital or analog settings 116 of the tunable filter 102 to approach the desired filter characteristic of the filter 102.

The apparatus 100 with its modules 104, 110, and 114 is configured to implement a corresponding filter tuning method. The method includes an act of determining the signal 106 indicative of the current filter characteristic based on the interaction of the reference signal 108 with the filter 102 having the current filter characteristic. The method further comprises an act of comparing the signal 106 indicative of the current filter characteristic with a signal 112 indicative of a desired filter characteristic of the filter 102. The method also includes an act of updating, based on the comparison act, one or more settings 116 of the tunable filter 102 to approach the desired filter characteristic.

In some embodiments the determination module 104, the comparison module 110, and the update module 114 may be implemented by means of one or more digital baseband processors for processing digital baseband and control signals. For example, the apparatus 100 may form a part of a digital baseband processor of a base station or a mobile station of a wireless communication system, such as, for example, wireless communication systems standardized by the 3^{rd} Generation Partnership Project (3GPP), such as the Global System for Mobile Communications (GSM), Enhanced Data rates for GSM Evolution (EDGE), GSM/EDGE Radio Access Network (GERAN), Universal Terrestrial Radio Access Network (UTRAN) or Evolved UTRAN (E-UTRAN), Long Term Evolution (LTE) or LTE-Advanced (LTE-A), or wireless communication systems with different standards, e.g. Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc.

In embodiments where the apparatus 100 forms a part of a digital baseband processor of a base station or a mobile station of a wireless communication system, the tunable filter 102 may comprise an analog RF filter for transmitting and/or receiving RF signals to or from other devices of the wireless communication system. In this context the reference signal 108 may be a time continuous RF reference signal carrying known reference symbols, such as an uplink or downlink reference signal, for example. In case the filter 102 is located in a base station, the reference signal 108 may be an uplink reference signal employed in a wireless communication system. In case the filter 102 is located in a mobile terminal the reference signal 108 may be a downlink reference signal employed in the considered wireless communication system. In such embodiments the reference signal 108 can be regarded as an external reference signal. Alternatively, the reference signal 108 may be generated by the apparatus 100 itself. In such embodiments the reference signal 108 can be regarded as an internal reference signal. In this case the apparatus may additionally comprise a reference signal generator (not shown).

In some embodiments subsequent interactions between the filter 102 and the reference signal 108 may take place periodically, for example with a periodicity depending on the effects that should be compensated. A time interval between subsequent reference signals 108 may range from microseconds to years. Other embodiments also allow for irregular tuning intervals. For example, tuning of the filter may only be initiated if a certain error threshold due to the filtering is exceeded. Hence, embodiments may employ open-loop or closed loop-control of the current filter characteristic. For example, determination module 104, the comparison module 110, and the update module 114 may be arranged to form a closed-loop control circuit for tuning the current filter characteristic to approach the desired filter characteristic of the filter 102.

In some embodiments the external or internal RF reference signal 108 may be passed through the analog RF filter 102 resulting in a filtered RF reference signal 108' carrying, due to the filter operation, information on the current filter characteristic (e.g. frequency and/or phase response) of the RF filter 102. Note that also other types of interaction between the reference signal 108 and the tunable filter 102 are conceivable. For example, a part of an RF reference signal 108 could also be reflected at an input port of the filter 102, leading to a reflected signal (not shown). This reflected signal may also carry information on the current filter characteristic of the RF filter 102. The filtered reference signal 108' or the reflected reference signal may be denoted as interactive signal 108' - due to the preceding interaction with the filter 102.

In some embodiments the interactive signal 108' may be down-converted from RF-band to baseband by means of conventional down-conversion circuits, which may be included in the determination module 104, for example. Down-conversion circuits are well-known in the art of wireless communications. Examples of down-conversion circuits may include mixers, Analog-to-Digital Converters (ADCs), and other adequate electrical circuitry. The resulting baseband signal 106, which may be complex-valued, corresponds to the filter operation with the analog RF filter 102 having the current undesired filter characteristic. That is to say, amplitude and/or phase values of the reference or pilot symbols included in the signal 106 have been modified according to the current undesired filter characteristic. Hence, the signal 106 may be regarded as a signal fingerprint of the current undesired filter characteristic.

In block 110 the baseband signal 106 comprising the amplitude and/or phase values of the modified reference symbols may be compared to another baseband signal 112, which serves as a baseband reference signal for the desired filter characteristic. Said baseband reference signal 112 may also comprise amplitude and/or phase values of modified reference symbols included in the reference signal 108. However, in the signal 112 the amplitude and/or phase values of the reference symbols are modified according to the desired filter characteristic of the filter 102. Hence, the baseband reference signal 112 may also be interpreted as a baseband signal fingerprint of the desired filter characteristic.

The comparison module 110 may evaluate a difference between the two baseband signals 106 and 112. This may be done in various ways. In one example, the difference may be evaluated in the time domain. In another example, the difference may be evaluated in the frequency domain, for example by performing a Fourier transform (for example a Fast Fourier Transform, FFT) of the baseband signals 106 and 112, respectively. The difference between the two baseband signals 106 and 112 is indicative of a difference between the current undesired and the desired filter characteristic of the tunable filter 102.

Based on a result of the comparison module 110 the update module 114 may then adjust at least one control setting 116 of the tunable filter 102 to reduce a difference between the current and the desired filter characteristic. The control settings 116 may correspond to electrical currents or voltages, digital control words for Digital-to-Analog Converters (DACs), electromechanical actuators, or the like. Hence, the at least one control setting 116 may be from the group consisting of a control voltage for one or more components of the tunable filter, a control word for a tunable inductance of the tunable filter, a control word for a tunable capacitance of the tunable filter, and a control word for a tunable resistance of the tunable filter, for example.

A challenge on applying embodiments may be detecting the current frequency characteristic at arbitrary time during operation. An example way to implement it will now be described for the receive path of a base station during LTE operation, where interference signals within the frequency band of the received signal may be blocked out by the filter 102. Some characteristics of the received LTE signal may be used to determine the frequency characteristic of the filter 102.

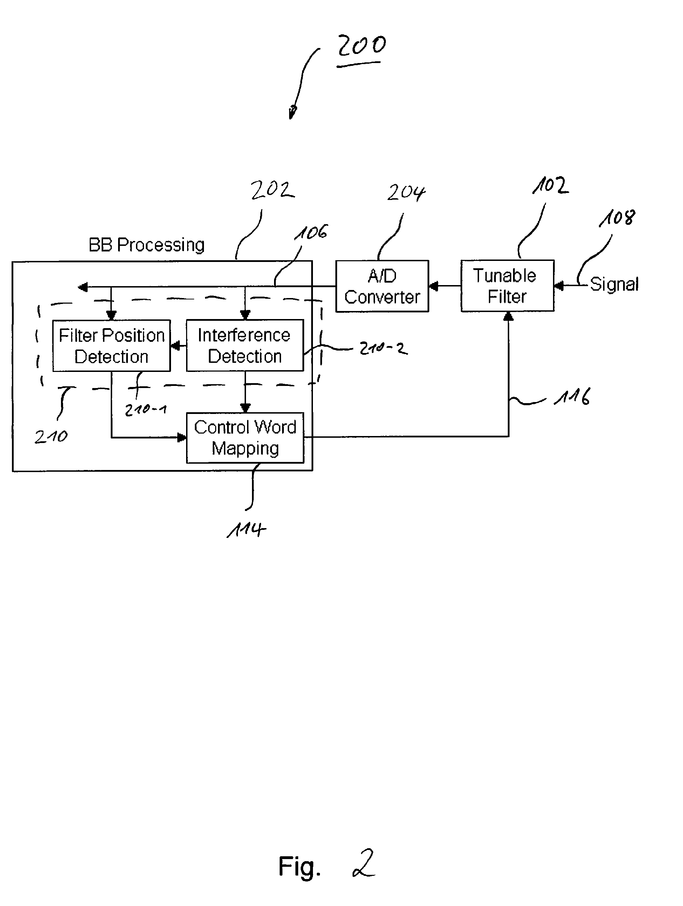

**Fig. 2** illustrates a schematic block diagram of another embodiment of an apparatus 200 for tuning or adjusting a tunable filter 102. The apparatus 200 comprises a digital baseband processor 202 which is coupled to a tunable analog filter 102 via an ADC 204. The analog filter 102 may be an RF receive filter.

In a calibration phase, desired operating frequencies of the tunable filter 102 may be mapped to certain control words 116, which can be stored for example in a Look-Up Table (LUT). The desired operating frequencies may correspond to the desired RF band of the received signal. During operating time, the digital baseband processor 202 may detect spectral interference within the RF receive band and set or update the tunable filter 102 with a corresponding control word to block out unwanted interference. However, temperature drifting and component aging can significantly change the characteristics of the tunable filter 102 over time and one can therefore not reach the desired filter characteristic with the calibrated control words.

Embodiments propose to update the mapping of the control words in order to compensate for the dynamical characteristics changing of tunable filter 102. As we are able to determine an exact frequency characteristic of the filter 102 using the digital baseband processor 202, we can calculate the difference between the desired frequency characteristic and the instantaneous frequency characteristic. Because the mapping between the filter frequency and control words may be chosen monotone, one can easily increase or decrease the control words step by step according to the sign of the frequency difference, until the frequency difference between the desired frequency characteristic and the instantaneous frequency characteristic equals zero or smaller than a predefined threshold. Alternatively, even more sophisticated algorithms may be applied. Consequently, the new control word may be stored for replacing the old one. In this way, one can update the control word mapping and thus fine-tune the filter 102 during operating time.

In the example of Fig 2, the baseband processing part 202 of the filter control is composed of three building blocks. Crucial functionality blocks involve the detection capabilities in the baseband. Two of these building blocks 210-1, 210-2 are related to the detection of the current filter position in the frequency domain and the detection of the position of the interfering signals. Note that the detection of the position of the interfering signals is possible as the reference signal 108 is an uplink reference signal transmitted to the base station from a mobile terminal. For both tasks a large variety of signal processing methods is applicable, most notably pilot based and statistical properties based methods.

For the detection of the filter position in block 210-1, the known filter characteristic may be compared to filter characteristic derived by the received signal (for example pilots). In one example, this may be performed as described before. The baseband signal 106 comprising the amplitude and/or phase values of the modified reference symbols of the reference signal 108 may be compared to another baseband signal, which serves as a baseband reference signal. Said baseband reference signal may also comprise amplitude and/or phase values of modified reference symbols included in the reference signal 108. However, in the baseband reference signal the amplitude and/or phase values of the reference symbols are modified according to the desired filter characteristic of the filter 102. As a result, the current position of the filter 102 may be evaluated. By evaluating the received pilot signal in block 210-1 one can determine the frequency position of a notch of the filter characteristic, for example. If it differs from a desired frequency position, one can therefore update the control word.

The interference may be detected in block 210-2 during a process of useful signal detection. Again, the interference may be determined by only analyzing the baseband signal 106 or/and by comparing the baseband signal 106 comprising the amplitude and/or phase values of the modified reference symbols of the reference signal 108 against a baseband reference signal (related to interference suppression), which also comprises amplitude and/or phase values of modified reference symbols included in the reference signal 108. However, in the baseband reference signal the amplitude and/or phase values of the reference symbols are modified according to the desired interference suppression characteristic of the filter 102. As a result, the current position of the filter 102 may be evaluated. The spectrum power density of the interference signal may in most cases be much larger than the wanted signal. Therefore, the interference signal would destroy the signal within the interference frequency band. For example, in LTE system, one may analyze the pilot signal of each LTE resource block. The interference signal stands exactly on these LTE subcarriers, in which the pilot signals are missing or cannot be detected.

The two estimations as outlined above may not be independent. For example, improved functionalities for interference detection imply also a more accurate estimation of the filter position. As depicted in Fig 2, the information gained via the two aforementioned signal analysis algorithms may be used to derive the control information 116 for the tuning of the filter 102.

The potential of embodiments may be demonstrated by simulations considering tunable filters based on cavity resonators implemented in printed circuit boards.

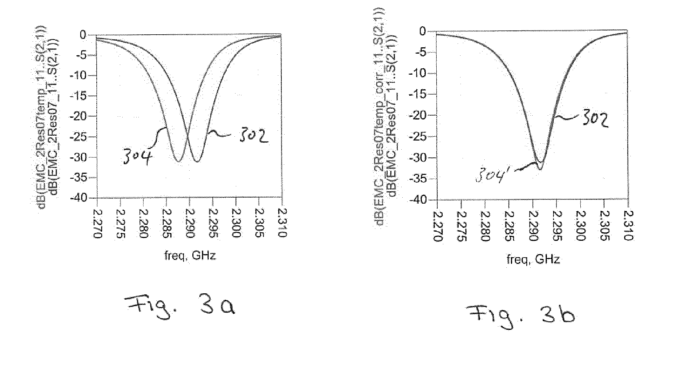

A temperature sensitivity of such filters is presented in Fig. 3a. The nominal frequency characteristic of a band stop filter is shown by curve 302, while curve 304 shows the drift of the characteristic when assuming +50 °C of temperature modification. The detuning of the filter is in the range of 70% of the considered 20 dB bandwidth.

**Fig. 3b** shows the correction of the detuned filter characteristic. Curve 302 again shows the same nominal characteristic as Fig. 3a. Curve 304' considers +50 °C of temperature modification combined with a correction of the detuning effect using an embodiment of the resent invention. For example, the filter 102 may be tuned voltage controlled. Control voltages with 10 mV resolution are assumed. The corrected characteristic 304' is not identical with the nominal one 302, but shows an excellent adaptation.

To summarize, embodiment propose the tuning of filters for correcting unforeseeable modification of frequency characteristics. Embodiments are based on procedures including:
- determination of the current filter or frequency characteristic by analyzing a signal passing through the filter (alternatively even other interactions of the signal with the filter can be considered to determine the filter characteristic, e.g. the reflection response of the filter.),
- comparing the current filter characteristic with the wanted filter characteristic and defining the required correction,
- defining the new settings for the tunable filter and initiating the required correction, and
- continuous repetition of these steps.

Embodiments allow to operate tunable filters of simple construction of high accuracy, lower cost, size and weight (e.g. with no temperature compensation implemented). Embodiments allow to compensate disturbing short time effects, e.g. due to temperature modification, as well as disturbing long time effects, e.g. due to material aging. Embodiments enable the operation of tunable filters of reduced stability with regard to their frequency characteristics but with an advantage of high accuracy, lower cost, size and weight.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "means or module for s.th." may as well be understood as a "means or module being adapted or suited for s.th.". A means or module being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. An apparatus (100; 200) for tuning a tunable filter (102), the apparatus comprising:
a determination module (104) to determine a signal (106) indicative of a current filter characteristic of the tunable filter (102) based on an interaction of a reference signal (108) with the tunable filter (102) having the current filter characteristic;
a comparison module (110) to compare the signal (106) indicative of the current filter characteristic with a signal (112) indicative of a desired filter characteristic of the tunable filter (102); and
an update module (114) to update, based on the comparison, one or more settings (116) of the tunable filter (102) to approximate the desired filter characteristic.

2. The apparatus (100; 200) of claim 1, wherein the determination module (104) comprises a digital baseband module operable to determine a digital baseband signal (106) originating from the interaction of the reference signal (108) with the tunable filter (102) having the current filter characteristic, such that the digital baseband signal (106) is indicative of the current filter characteristic of the filter (102).

3. The apparatus (100; 200) of claim 1, wherein the tunable filter (102) is an analog filter.

4. The apparatus (100; 200) of claim 1, wherein the tunable filter (102) is a tunable Radio Frequency (RF) filter and the reference signal (108) is a RF signal.

5. The apparatus (100; 200) of claim 1, wherein the reference signal (108) comprises predetermined pilot symbols.

6. The apparatus (100; 200) of claim 1, wherein the reference signal (108) is from the group consisting of an uplink reference signal of a mobile communication system and a downlink reference signal of a mobile communication system.

7. The apparatus (100; 200) of claim 1, wherein the interaction of the reference signal (108) with the tunable filter (102) is from the group of the reference signal (108) passing through the tunable filter (102) and the reference signal (108) being reflected from the tunable filter (102).

8. The apparatus (100; 200) of claim 2, wherein the comparison module (110) is operable to compare the digital baseband signal (106) corresponding to the current filter characteristic with a digital baseband reference signal (112) corresponding to an interaction of the reference signal (108) with the tunable filter (102) having the desired filter characteristic.

9. The apparatus (100; 200) of claim 8, wherein the comparison module (110) is operable to evaluate a difference between the digital baseband signal (106) corresponding to the current filter characteristic and the digital baseband reference signal (112).

10. The apparatus (100; 200) of claim 1, wherein the update module (114) is operable to adjust at least one control setting (116) of the tunable filter (102) in order to reduce a difference between the signal (106) indicative of the current frequency characteristic and the signal (112) indicative of the desired frequency characteristic, wherein the at least one control setting (116) is from the group consisting of a control voltage of the tunable filter, a tunable inductance of the tunable filter, a tunable capacitance of the tunable filter, and a tunable resistance of the tunable filter.

11. The apparatus (100; 200) of claim 1, wherein the determination module (104), the comparison module (110), and the update module (114) are arranged to form a closed-loop control circuit for tuning the current filter characteristic to approach the desired filter characteristic of the filter (102).

12. The apparatus (100; 200) of claim 1, wherein the tunable filter (102) is a receive filter of a base station or a mobile station of a mobile communication system.

13. The apparatus (100; 200) of claim 1, wherein current frequency characteristic deviates from the desired frequency characteristic due to at least one effect of the group consisting of filter component aging and influence of temperature on the filter components.

14. A method for tuning a tunable filter, the method comprising:
determining a signal (106) indicative of a current filter characteristic of the tunable filter (102) based on an interaction of a reference signal (108) with the tunable filter (102) having the current filter characteristic;
comparing the signal (106) indicative of the current filter characteristic with a signal (112) indicative of a desired filter characteristic of the tunable filter (102); and
updating, based on the comparison, one or more settings (116) of the tunable filter (102) to approximate the desired filter characteristic.

15. A computer program having a program code for performing the steps of the method of claim 14, when the computer program is executed on a programmable hardware device.
